Europäisches Patentamt

(19) European Patent Office

Office européen des brevets

(11) Publication number: **0 008 380**
**B1**

(12) **EUROPEAN PATENT SPECIFICATION**

(45) Date of publication of patent specification: **14.10.81**

(21) Application number: **79102645.3**

(22) Date of filing: **25.07.79**

(51) Int. Cl.³: **G 01 R 31/02,**
**G 01 R 31/28**

(54) **Electronic circuit assembly for testing module interconnections.**

(30) Priority: **18.08.78 US 934936**

(43) Date of publication of application:
**05.03.80 Bulletin 80/5**

(45) Publication of the grant of the European patent:
**14.10.81 Bulletin 81/41**

(84) Designated Contracting States:
**DE FR GB**

(56) References cited:
**US - A - 3 795 860**

**IBM TECHNICAL DISCLOSURE BULLETIN,
vol. 14, no. 10, March 1972,
New York, US,
A.D. SAVKAR: "N-Way Testpoint for Complex
LSI Design", pages 2937, 2938.**

(73) Proprietor: **International Business Machines
Corporation
Armonk, N.Y. 10504 (US)**

(72) Inventor: **Hong, Se June
15 Barnard Avenue
Poughkeepsie, New York 12601 (US)**

(74) Representative: **Richards, John Peter
IBM UNITED KINGDOM PATENT OPERATIONS
Hursley Park
Winchester Hants, SO21 2JN (GB)**

Courier Press, Leamington Spa, England.

Electronic circuit assembly for testing module interconnections

The present invention relates to an electronic circuit assembly of the kind comprising a plurality of logic circuit modules mounted on an insulating base and more particularly to circuitry in the modules to provide simple testing of such assemblies.

Before integrated circuit modules are finally mounted on an insulating base (herein referred to as a card), the modules are each thoroughly tested individually and the wiring or interconnection network on the card is also tested. The faults introduced by the assembly of the modules on the card generally stem from defective connections between the pins of the modules and the card wiring and do not, however, destroy the internal logic circuits of the modules. Therefore what really needs to be tested after the assembly of the modules on the cards is the connections between the modules and the card. In the past the layout of the modules has been such that this test can not be accomplished without taking into account the already tested circuitry on the module. Since this circuitry is rich in interconnections, generating tests for defective pin connections becomes an enormous task. More specifically, when the card I/O pins are the only accessible points for testing the test generation process must take into account the whole card full of logic circuits; that is, all the logic circuits on each of the modules mounted on the card. The fact that the fault sites are only at the module boundary, that is, at the pins of the module, does not make the job any easier. Even when the module pins are observable at the card testing one still has to find test inputs that will deliver sensitizing logic values to the module inputs.

In our co-pending application 79102334.4. (IBM Docket PO9—78—001) a testing technique is described which can be used to test the connections between the module and a card using circuits in the modules in combination with mechanical probing of the card.

It is an object of the present invention to provide an electronic circuit assembly that permits the testing of interconnections with a very simple electrical test that does not require mechanical probing.

According to the present invention there is provided an electronic circuit assembly in which a plurality of modules containing logic circuitry are mounted on a insulating base having an interconnection network selectively interconnecting input and output terminals of the modules with one another and with terminals of the circuit assembly, characterised in that for testing the assembly each module comprises in addition to the logic circuitry an Exclusive-OR circuit tree means connecting the input terminals of the module to a test output terminal of the module, and masking and test circuit means activatable when testing is desired, for coupling the output terminals of the module to a test input terminal of the module and simultaneously isolating the outputs of the logic circuitry from the output terminals and the base comprises circuit means for activating the masking and test circuit means when desired and supplying test signals to the test input terminals of the modules.

The term "module" as used in this specification means a sub-assembly comprising one or more integrated circuit elements or chips.

IBM Technical Disclosure Bulletin, Vol. 14, no. 10, March 1972, pages 2937—2938 and U.S. Patent 3,795,860 relate to various aspects of testing LSI chips and wiring networks, and may provide useful background art to the present invention. However, neither document is concerned with testing an assembly comprising a number of logic circuit modules on an insulating card.

Embodiments of the invention will now be described, by way of example, with reference to the accompanying drawings, in which:

Fig. 1 is a schematic view of a portion of a card embodying the present invention that permits testing of the module pin-to-card wiring connections without probing the card or modules;

Fig. 2 is a schematic view of a portion of a card showing a modification to be made in the embodiment of Fig. 1 when two input pins of a module are connected to a single input line;

Fig. 3 is a schematic view of a portion of a card embodying the invention which permits the testing of interconnection nets on the cards along with the connections between the module pins and the card wiring; and

Fig. 4 is a schematic view of a card containing the embodiment of Fig. 3 with test signals superimposed on the terminals and pins of the card.

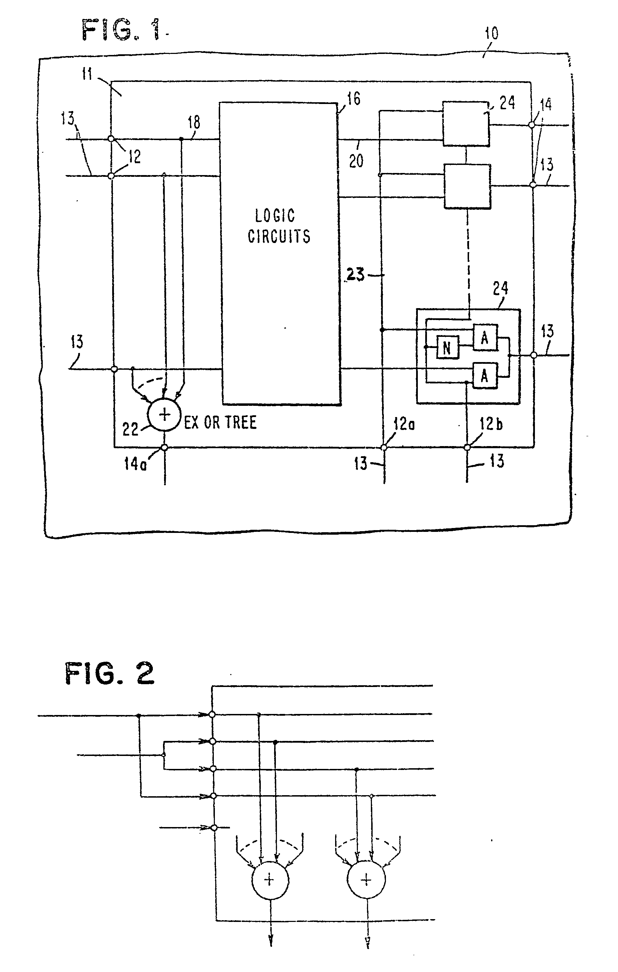

In the embodiment shown in Fig. 1, each of a plurality of integrated logic circuit modules 11 mounted on a card 10 contains a plurality of both input pins 12 and output pins 14. These pins 12 and 14 are selectively connected by conductors 13 of an interconnection network on the card 10 to output and input pins of other modules on the card and to the input and output terminals of the card itself.

The logic circuits 16 in each of the modules 11 are connected to the input pins 12 by input lines 18 and to the output pins 14 by output lines 20. There are additional circuits provided in each of the modules by this embodiment. These include an Exclusive-OR tree 22 which receives an input from each of the input pins 12 and has a single output which is taken off the module at a test output pin 14a. Furthermore, each output line 20 is connected through a half-select or masking circuit 24 to an output pin 14 of the module. The masking circuits have two inputs. One of the inputs is from one of the output lines 20. The other input is from a line 23 connected to a test input pin 12a. The outputs of the masking circuits each go to one of the output pins 14 while respective control terminals for each of the circuits 24 are connected to a control input pin 12b.

All the test input pins 12a of all the modules on the card are connected to a first common card terminal and all the control input pins 12b are connected to a second common card terminal. Furthermore, each pin 14a is connected to a respective card terminal. Thus the card has a total of (2 plus number of modules) additional input and output terminals to perform tests in accordance with the present embodiment and each module has three additional input and output pins as shown in Fig. 1.

During normal operation, that is, operation when the modules are not being tested, a binary 1 is applied to each of the pins 12b via the common card terminal. This connects the output lines 20 of the logic circuits to the output pins 14 so the circuits 16 on the cards can perform in their intended manner. When the circuits are to be tested, however, a binary 0 is applied to the pins 12b on all the modules. This de-gates the connection between the output lines 20 of the logic circuits 16 and the pins 14 and instead connects all the pins 14 to line 23, so that test signals can be applied to the output pins 14 by their application to the common card terminal connected to pins 12a of all the modules.

The test signals are a binary 0 followed by a binary 1. The first signal (binary 0) tests for any pin stuck at 1. If the card tests good, a binary 0 will appear at all the card terminals connected to respective module pins 14a, if not a binary 1 appears at one or more of these terminals. The second signal (binary 1) tests for any pin stuck at binary 0. If the card tests good a binary 1 will appear in response to the test, while a bad card will produce a binary 0 in response thereto. This would give an indication as to where the bad connection occurred.

In making the above test two presumptions were made. One is that there are an odd number of inputs to each module. The other is that one source does not go to two inputs on a single module. If the first presumption is not true for any module 11 a dummy input can be provided to the Exclusive-OR circuit of that module from an additional input pin. If the second presumption is not true, the problem can be overcome by the modification shown in Fig. 2.

A simple embodiment of the invention has been described above. What follows is a description of a more complex embodiment which permits testing for shorts between the separate portions of the interconnection network on the card in addition to testing for simple stuck 1's or 0's in those networks. This eliminates the need for a card wiring test.

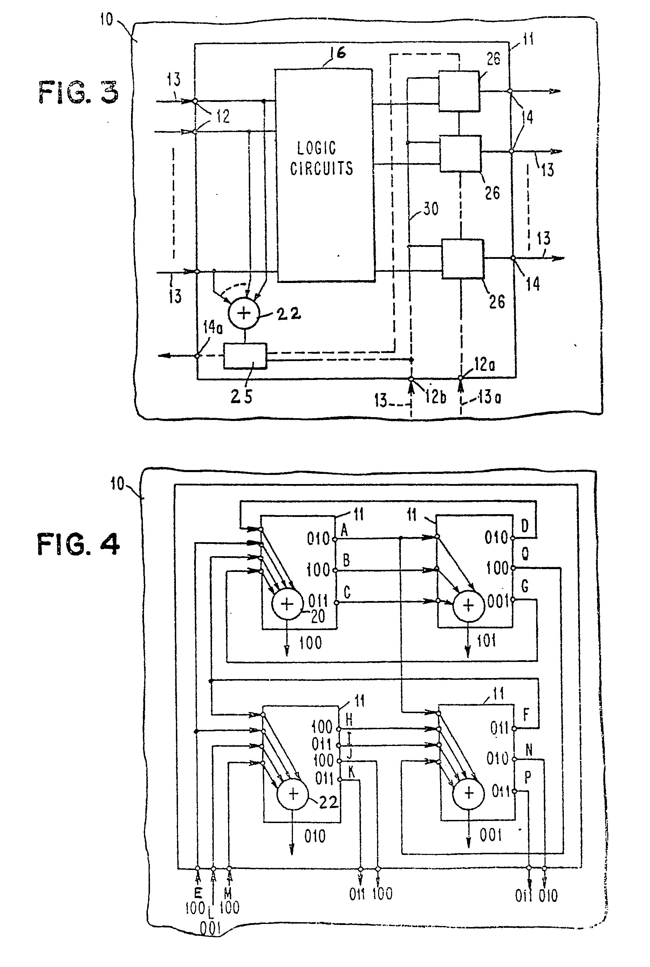

As shown in Fig. 3, each module includes an Exclusive-OR circuit 22 with an input coupled to each of the module input pins 12 and output connected to a stage 25 of a shift register of the type described in U.S. Patent 3,993,919. In addition the output pins 14 are each connected to a stage 26 of the same shift register. Data can be loaded into the first stage of this shift register at input terminal 12a, stepped through all stages of the shift register with clock signals and removed from the last stage of the shift register at output terminal 14a. Data can also enter all shift register stages in parallel from the logic circuits 16 and from the output of the Exclusive-OR tree 22.

How data is entered into the shift register is determined by the timing, set and reset signals described in the above mentioned U.S. patent and is represented symbollically by line 30 coupled to input pin 12b. Thus the stages 26 could each be loaded with a "1" or a "0" through pin 12a while the shift register is in serial mode, thereater the shift register could be changed to parallel data mode and the response of Exclusive-OR tree captured in stage 25 and then the shift register could be returned to serial data mode to read the response in stage 25 out of pin 14a. This process can be repeated any number of times so that a whole series of bits can be loaded into each of the stages and each time the stages are loaded the response of the Exclusive-OR tree 22 can be taken off the module.

The shift registers of all the modules 11 on the card can be arranged in series and data shifted through all shift registers. If the shift registers are arranged in series only one input terminal and one output terminal of the card are needed for all the shift registers. If the shift registers are not so arranged a separate set of card input and output terminals are needed for each shift register.

To use the circuitry shown in Fig. 3 to check the interconnections on the card for shorts between separate portions thereof the number of such separate portions (referred to hereinafter as nets) on the card must be determined.

The number of nets on the card is equal to the number of source pins for the nets which include all the module output pins and the card primary input terminals. Let us say there are N nets on a card. Typically the number of nets is less than 1000. The number of tests, n, for the comprehensive method can be given as

$$ n \leq [1 + \lfloor \log_2 N \rfloor] \text{ for } N > 2 $$

This works as follows:

i) To test every pin stuck at 0 and 1, each net should have at least one 0 value and at least one 1 value in the test.
ii) When two nets short together, the value of one dominates the other, therefore any net that may short (adjacent somewhere in the card) must have at least one opposing value pair in the test.

iii) If the Exclusive-OR output value is observed not through a shift register, but through a separate pin, the test inputs arriving at each module must have at least one odd parity case and at least one even parity case to test the stuck faults of the Exclusive-OR output pin itself.

A simple approach to i) and ii) is to assign to each net a unique non-zero binary ID of length $1 + \log_2 N$. When each source produces its own ID, all single stuck or short faults are detected through at least one Exclusive-OR gate.

The total number of tests required in this method is already very small; however, if not all nets can snort, one can derive a shorter test by non-unique ID assignment, i.e., the nets that never cross or parallel each other can have the same ID. This kind of analysis is probably not very important in a practical sense. The general method of doing this can be summarized as:

1) Construct compatibility table of non-adjacent nets,

2) generate minimal number, k, of covering compatibles,

3) assign $1 + \log_2 k$ bit long non-zero unique ID's to the compatibles.

The condition iii) for testing the Exclusive-OR output pin, if necessary, can be satisfied easily by a simple trial and error process as follows:

1) Check all module inputs to see if there at least one even parity input and one odd parity input in the tests,

2) if some modules have test inputs entirely of the same parity, permute some ID's one at a time and check again.

The above juggling produces good assignments in a few trials. An example of reduced tests for module pins and card wiring is shown in Fig. 4 and the following table.

INCOMPATIBILITY TABLE

| NET | ADJACENT TO |
|-----|-------------|
| A | B C F G H |
| B | A C |
| C | A B |
| D | E F |
| E | D F L |
| F | A D E G N |
| G | A F Q |
| H | A I |
| I | H J Q |
| J | I K |

INCOMPATIBILITY TABLE

| NET | ADJACENT TO |
|-----|-------------|
| K | J |
| L | E M |
| M | L |
| N | F P Q |
| P | N Q |
| Q | D F G I N P |

One minimal covering compatibles has 4 compatibles as follows:

{G,L},   {A,D,N,},   {C,F,I,K,L,P},   {B,E,H,J,M,Q}

assigned ID

001     010     011     100

The card in Fig. 4 has three input terminals and there are a total of 13 output pins on the modules of the card. Therefore there is a total of 16 nets on the card. However as can be seen by the above analysis three tests are all that is needed when non-adjacent nets are excluded. It is to be understood that, for clarity, the logic and masking circuits are not shown in the modules 11 of fig. 4 although they are of course present.

**Claims**

1. An electronic circuit assembly in which a plurality of modules (11) containing logic circuitry (16) are mounted on a insulating base (10) having an interconnection network selectively interconnecting input (12) and output (14) terminals of the modules with one another and with terminals of the circuit assembly, characterised in that for testing the assembly each module (11) comprises in addition to the logic circuitry (16) an Exclusive-OR circuit tree means (22) connecting the input terminals (12) of the modules (11) to a test output terminal (14a) of the modules, and masking and test circuit means (12a, 12b, 23 and 24, fig. 1, or 26, fig. 3), activatable when testing is desired, for coupling the output terminals (14) of the module to a test input terminal (12a) of the module and simultaneously isolating the outputs (20) of the logic circuitry (16) from the output terminals (14), and the base (10) comprises circuit means for activating the masking and test circuit means when desired and supplying test signals to the test input terminals (12a) of the modules.

2. The electronic circuit assembly of claim 1, wherein each masking and test circuit means includes a plurality of shift register stages (26) in which each stage of the shift register is coupled to one of the output terminals (14) of the module (11) whereby a plurality of test signals can be applied to the output terminals by shifting them in series through the stages and then in parallel to the output terminals.

3. The electronic circuit assembly of claim 1, wherein the masking and test circuit means of each module comprises a plurality of half-select circuits (24) each with an output connected to one of the output terminals (14) of the module, one input connected to an output of the logic circuitry (16), the other input connected to the test input terminal (12a) of the module, and a control input connected to a common control terminal (12b) of the module.

4. The electronic circuit assembly of claim 3, wherein the circuit means on the base connects the test output terminals (14a) of the modules to respective output terminals of the assembly, connects all the test input terminals (12a) of the modules together to a common input terminal of the assembly, and connects all the control terminals (12b) of the modules together to a common control terminal of the assembly.

Revendications

1. Montage de circuits électroniques dans lequel plusieurs modules (11) contenant des circuits logiques (16) sont montés sur une embase isolante (10) comportant un réseau d'interconnexion interconnectant sélectivement les bornes d'entrée (12) et de sortie (14) des modules les unes avec les autres et avec les bornes du montage de circuits, caractérisé en ce que, pour tester le montage, chaque module (11) comprend outre les circuits logiques (16), une structure en arbre (22) à circuits OU exclusifs connectant les bornes d'entrée (12) du module (11) à une borne de sortie de test (14a) du module, et des circuits de masquage et de test (12a, 12b, 23 et 24, Figure 1, ou 26, Figure 3), que l'on actionne lorsqu'une opération de test est désirée, pour coupler les bornes de sortie (14) du module à une borne d'entrée de test (12a) du module et pour isoler simultanément les sorties (20) des circuits logiques (16) des bornes de sortie (14), et en ce que l'embase (10) comprend des circuits pour exciter les circuits de masquage et de test lorsqu'on le désire et délivrer des signaux de test aux bornes d'entrée de test (12a) des modules.

2. Montage selon la revendication 1, caractérisé en ce que chaque circuit de masquage et de test comprend plusieurs étages (26) de registre à décalage qui sont chacun couplés à l'une des bornes de sortie (14) du module (11), ce qui permet à plusieurs signaux de test de pouvoir être appliqués aux bornes de sortie en les décalant en série au travers les étages, puis en parallèle aux bornes de sortie.

3. Montage selon la revendication 1, caractérisé en ce que les circuits de masquage et de test de chaque module comprennent plusieurs circuits de demi-sélection (24) présentant chacun une sortie connectée à l'une des bornes de sortie (14) du module, une entrée connectée à une sortie des circuits logiques (16), l'autre entrée connectée à la borne d'entrée de test (12a) du module et une entrée de commande connectée à une borne de commande commune (12b) du module.

4. Montage selon la revendication 3, caractérisé en ce que le circuit de l'embase connecte les bornes de sortie de test (14a) des modules aux bornes de sortie respectives du montage, connecte toutes les bornes d'entrée de test (12a) des modules ensemble à une borne d'entrée commune du montage, et connecte toutes les bornes de commande (12b) des modules ensemble à une borne de commande commune du montage.

Patentansprüche

1. Elektronische Schaltungsanordnung mit mehreren, logische Schaltungen (16) enthaltenden Moduls (11) auf einer isolierenden Grundplatte (10), die ein selektiv Eingänge (12) und Ausgänge (14) der Moduls (11) untereinander und mit Anschlüssen der Schaltungsanordnung verbindendes Leitungsnetzwerk trägt, dadurch gekennzeichnet, daß zum Testen der Schaltungsanordnung jedes Modul (11) zusätzlich eine exklusive ODER-Schaltung (22), die die Eingänge (12) des Moduls (11) mit einem Testschaltungsausgang (14a) des Moduls verbindet, und eine beim Testen aktivierte Ausblend- und Testschaltung (12a, 12b, 23, 24, Fig. 1, oder 26, Fig. 3) enthält, die die Ausgänge (14) des Moduls (11) mit einem Testschaltungseingang (12a) des Moduls verbindet und gleichzeitig die Ausgänge (20) der logischen Schaltung (16) von Ausgängen (14) des Moduls (11) isoliert, und daß die Grundplatte (10) eine Aktivierungsschaltung enthält, über die die Ausblend- und Testschaltung aktivierbar ist und die Testsignale an die Testschaltungseingänge liefert.

2. Elektronische Schaltungsanordnung nach Anspruch 1, bei der jede Ausblend- und Testschaltung eine Vielzahl von Schieberegisterstufen (26) enthält, von denen jede mit jeweils einem der Ausgängen (14) des Moduls (11) gekoppelt ist, so daß den Ausgängen eine Vielzahl von Testsignalen zugeführt werden kann, wenn diese Testsignale seriell durch das Schieberegister und parallel zu den Ausgängen verschoben werden.

3. Elektronische Schaltungsanordnung nach Anspruch 1, bei der die Ausblend- und Testschaltung jedes Moduls (11) eine Vielzahl von Halb-Selektionsschaltungen (24) enthält, von denen jede mit einem Ausgang an einem der Eingänge (14) des Moduls (11) mit einem Eingang an einen Ausgang der logischen Schaltung (16), mit dem anderen Eingang an den Testschaltungseingang (12a) und mit einem Steuereingang an einen Steuereingang (12b) des Moduls (11) angeschlossen ist.

4. Elektronische Schaltungsanordnung nach Anspruch 3, bei der die Aktivierungsschaltung die Testschaltungsausgänge (14a) des Moduls (11) mit zugeordneten Ausgängen der Schaltungsanordnung, bei der alle Testschaltungseingänge (12a) der Moduls mit einem gemeinsamen Eingang der Schaltungsanordnung und bei der alle Steuereingänge (12b) der Moduls (11) mit einem gemeinsamen Steuereingang der Schaltungsanordnung verbunden sind.

FIG. 1.

LOGIC
CIRCUITS

EX OR TREE

FIG. 2

FIG. 3

FIG. 4